# EUROPEAN PATENT APPLICATION

(11) **EP 1 916 678 A1**
(43) Date of publication of application: **30.04.2008**
(21) Application number: 06832484.7
(22) Date of filing: 10.11.2006
(51) Int. Cl.: H01F 27/29, H01F 17/00

(54) **ELECTRONIC COMPONENT AND PRODUCTION METHOD THEREOF**

(30) Priority: 11.11.2005 JP 2005327211
(71) Applicant: Matsushita Electric Industrial Co., Ltd., Kadoma-shi Osaka 571-8501 (JP)
(72) Inventor: TAOKA, Mikio c/o Matsushita Electric Ind. Co. Ltd., Shiromi, Chuo-ku, Osaka-shi, Osaka, 540-6207 (JP); KUMEJI, Y. c/o Matsushita Electric Ind. Co. Ltd., Shiromi, Chuo-ku, Osaka-shi, Osaka, 540-6207 (JP); UEMATSU, H. c/o Matsushita Electric Ind. Co. Ltd., Shiromi, Chuo-ku, Osaka-shi, Osaka, 540-6207 (JP)
(74) Representative: Pautex Schneider, Nicole Véronique
(86) International application number: PCT/JP2006/322432
(87) International publication number: WO 2007/055303

(57) **Abstract**

There is provided an electronic component formed by adopting an adhesion reinforcement structure to an external electrode or the like, which is embedded in a protecting section made of a resin and part of which is exposed. Even when an external force is applied through the external electrode, the external force can be broadly dispersed all over a connecting section with the protecting section due to the adhesion reinforcement structure, to suppress an influence of the external force on a wiring, and whereby it is possible to omit a substrate that has been one of constitutional elements of a conventional electronic component, so as to realize reduction in height of the electronic component by the height of the substrate.

## Description

### TECHNICAL FIELD

The present invention relates to an electronic component for use in a variety of mobile phones, portable terminals and the like, and a production method thereof.

### BACKGROUND ART

The conventional electronic component has been formed on a substrate for example as disclosed in Unexamined Japanese Patent Publication No. H09-270355.

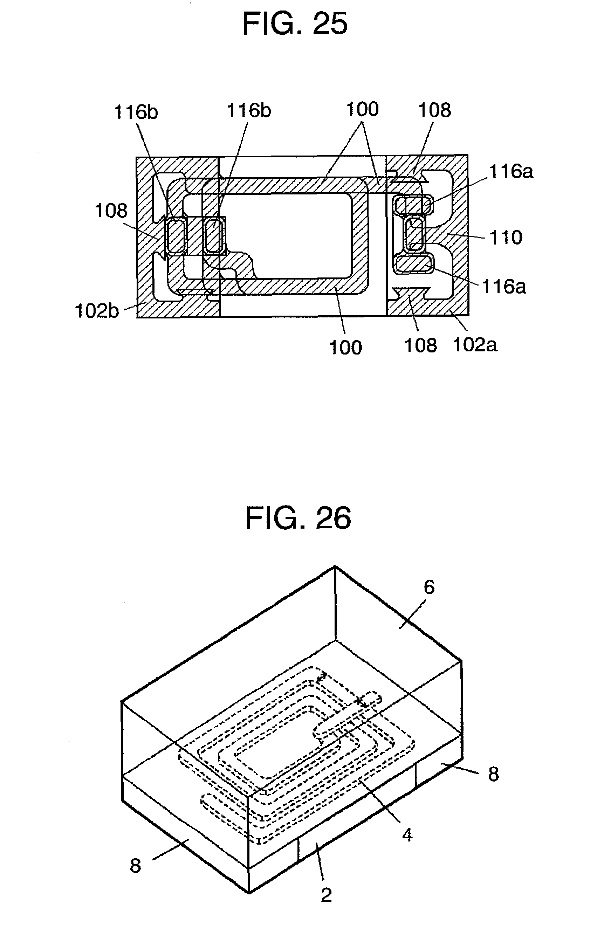

The conventional electronic component is described with reference to FIG. 26, taking a planar coil as an example. FIG. 26 is a perspective view of a planar coil, and coil-shaped or spiral-shaped wiring 4 is formed on substrate 2 such as an alumina substrate, which is protected by mold resin 6. Further, external electrode 8 is connected to both ends of wiring 4. The planar coil is then mounted on a printing wiring substrate through external electrode 8. Meanwhile, the electronic component after mounting is required to have predetermined mounting strength. By the use of substrate 2 as its constituent, the conventional electronic component is equipped with external electrode 8, wiring 4 and mold resin 6 with substrate 2 as a core. In this manner, the reliability and shock-resistance of the device have been enhanced.

In the case of the electronic component of FIG. 26, although external force is transmitted to the inside of the component through external electrode 8, the external force can be absorbed on substrate 2 side by previously making the strength of substrate 2 sufficiently large, thereby suppressing an influence of the external force on the inside of the component and wiring 4.

In the meantime, the device side requires the electronic component side to reduce its height. The requirement for height reduction has hitherto been dealt with by reducing the thickness of the substrate, however there has been a limitation on reduction in height of the electronic component so long as the substrate is to be used.

Namely, since substrate 2 has been used in the conventional electronic component for obtaining the predetermined mounting strength, the thickness of substrate 2 has exerted an influence on the whole thickness, causing the problem with the device not sufficiently dealing with the need for reducing its weight, thickness and size.

### DISCLOSURE OF THE INVENTION

The present invention has been made to solve the conventional problem, and has an object to omit a substrate from constituents of an electronic component so as to provide an electronic component that realizes further reduction in its height.

In the electronic component of the present invention, an adhesion reinforcement structure is employed in place of a substrate. An external force applied to the electronic component has hitherto been absorbed into the substrate, whereas the external force is diffused and dispersed all over a protecting section made of a resin in the adhesion reinforcement structure of the present invention so that direct transmission of the external force to the coil section can be suppressed.

In an electronic component and a production method thereof according to the present invention, it is possible to reduce the height of the electronic component without impairing the mounting strength thereof.

### BRIEF DESCRIPTION OF THE DRAWINGS

FIG. 1A is a view explaining an electronic component in Embodiment 1 of the present invention;
FIG. 1B is a view explaining the electronic component in Embodiment 1 of the present invention;
FIG. 1C is a view explaining the electronic component in Embodiment 1 of the present invention;
FIG. 2A is a view explaining a structure of the electronic component according to Embodiment 1;
FIG. 2B is a view explaining the structure of the electronic component according to Embodiment 1;
FIG. 2C is a view explaining the structure of the electronic component according to Embodiment 1;
FIG. 3A is a schematic view specifically explaining Embodiment 1;
FIG. 3B is a schematic view specifically explaining Embodiment 1;
FIG. 3C is a schematic view specifically explaining Embodiment 1;
FIG. 3D is a schematic view specifically explaining Embodiment 1;
FIG. 4A is a schematic view showing a condition of the case of not using an external electrode-via connecting section;
FIG. 4B is a schematic view showing a condition of the case of not using the external electrode-via connecting section;
FIG. 5A is a schematic view showing the external electrode-via connecting section;
FIG. 5B is a schematic view showing the external electrode-via connecting section;
FIG. 6A is a schematic view explaining a connecting position of the external electrode and wirings;
FIG. 6B is a schematic view explaining a connecting position of the external electrode and the wirings;
FIG. 7 is a schematic view explaining an electronic component in Embodiment 2;
FIG. 8A is a sectional view explaining a condition where wirings are formed on a substrate by a semi-additive method in Embodiment 3;
FIG. 8B is a sectional view explaining the condition where the wirings are formed on the substrate by the semi-additive method in Embodiment 3;
FIG. 8C is a sectional view explaining the condition where the wirings are formed on the substrate by the semi-additive method in Embodiment 3;
FIG. 8D is a sectional view explaining the condition where the wirings are formed on the substrate by the semi-additive method in Embodiment 3;
FIG. 9A is a sectional view explaining a condition where the wirings are formed on the substrate by the semi-additive method in Embodiment 3;
FIG. 9B is a sectional view explaining the condition where the wirings are formed on the substrate by the semi-additive method in Embodiment 3;
FIG. 9C is a sectional view explaining the condition where the wirings are formed on the substrate by the semi-additive method in Embodiment 3;
FIG. 10A is a sectional view explaining a method for manufacturing an electronic component according to Embodiment 4 of the present invention;
FIG. 10B is a sectional view explaining the method for manufacturing an electronic component according to Embodiment 4 of the present invention;
FIG. 10C is a sectional view explaining the method for manufacturing an electronic component according to Embodiment 4 of the present invention;
FIG. 11A is a sectional view explaining a method for manufacturing an electronic component according to Embodiment 4 of the present invention;
FIG. 11B is a sectional view explaining the method for manufacturing an electronic component according to Embodiment 4 of the present invention;
FIG. 12A is a sectional view explaining a method for manufacturing an electronic component according to Embodiment 4 of the present invention;
FIG. 12B is a sectional view explaining the method for manufacturing an electronic component according to Embodiment 4 of the present invention;
FIG. 13A is a sectional view explaining a method for manufacturing an electronic component according to Embodiment 4 of the present invention;
FIG. 13B is a sectional view explaining the method for manufacturing an electronic component according to Embodiment 4 of the present invention;
FIG. 14 is a sectional view explaining a method for manufacturing an electronic component according to Embodiment 4 of the present invention;
FIG. 15A is a schematic view explaining Embodiment 5;
FIG. 15B is a schematic view explaining Embodiment 5;
FIG. 16A is a schematic view explaining Embodiment 5;
FIG. 16B is a schematic view explaining Embodiment 5;
FIG. 16C is a schematic view explaining Embodiment 5;
FIG. 17A is a schematic view explaining Embodiment 5;
FIG. 17B is a schematic view explaining Embodiment 5;
FIG. 17C is a schematic view explaining Embodiment 5;
FIG. 17D is a schematic view explaining Embodiment 5;
FIG. 18A is a schematic view explaining Embodiment 6;
FIG. 18B is a schematic view explaining Embodiment 6;
FIG. 19A is a schematic view explaining Embodiment 6;
FIG. 19B is a schematic view explaining Embodiment 6;
FIG. 19C is a schematic view explaining Embodiment 6;
FIG. 20A is a schematic view explaining Embodiment 6;
FIG. 20B is a schematic view explaining Embodiment 6;
FIG. 20C is a schematic view explaining Embodiment 6;
FIG. 20D is a schematic view explaining Embodiment 6;
FIG. 21A is a schematic view explaining Embodiment 7;
FIG. 21B is a schematic view explaining Embodiment 7;
FIG. 22A is a schematic view explaining Embodiment 7;
FIG. 22B is a schematic view explaining Embodiment 7;
FIG. 22C is a schematic view explaining Embodiment 7;
FIG. 23A is a schematic view explaining Embodiment 7;
FIG. 23B is a schematic view explaining Embodiment 7;
FIG. 23C is a schematic view explaining Embodiment 7;
FIG. 23D is a schematic view explaining Embodiment 7;
FIG. 24A is a schematic view explaining Embodiment 8;
FIG. 24B is a schematic view explaining Embodiment 8;
FIG. 25 is a schematic view explaining Embodiment 8; and
FIG. 26 is a perspective view of a planar coil.

### REFERENCE MARKS IN THE DRAWINGS

- 100: Coil wiring
- 102: External electrode
- 102a: External electrode (first external electrode)
- 102b: External electrode (second external electrode)
- 104: Protecting section
- 106: Via
- 108, 109: Projection
- 110: External electrode-via connecting section
- 112, 113: Arrow
- 114: Depression
- 116: Substrate resin
- 118: Plating electrode
- 120: Resist pattern
- 122: Wiring
- 124: Arrow
- 126: Dotted line
- 130: Substrate electrode
- 132: Metal
- 134: Light
- 136: Mask
- 138: Light shielding section
- 140: Uncured photosensitive resist
- 142: Hole
- 201, 202, 205, 206, 207, 208: Electronic component

### PREFERRED EMBODIMENTS FOR CARRYING OUT OF THE INVENTION

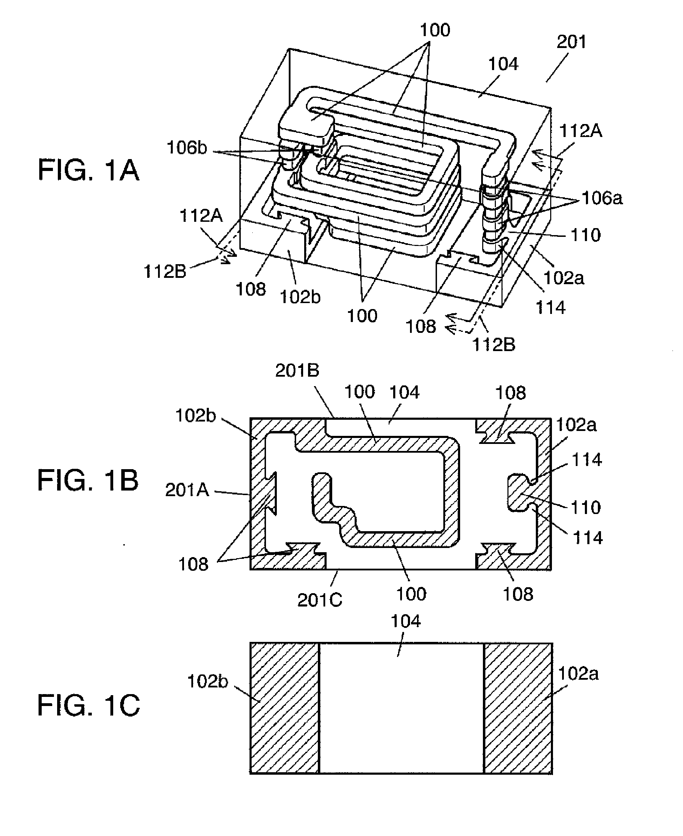

In the following, embodiments are specifically described with reference to drawings. It is to be noted that, for example in the case of comprehensively expressing FIGS. 1A, 1B and 1C, it is referred to as FIG. 1. The same comprehensive expression may also apply to figures other than FIG. 1. Further, for example in the case of comprehensively expressing external electrodes 102a and 102b, it is referred to as external electrode 102. The same comprehensive expression may also apply to symbols/numerals other than external electrode 102. Here, external electrode 102a corresponds to a first external electrode, and external electrode 102b corresponds to a second external electrode. The first external electrode and the second external electrode are each connected to a wiring or the like formed on a wiring substrate through solder or the like.

### Embodiment 1

In the following, a structure of an electronic component in Embodiment 1 of the present invention is described with reference to drawings. FIG. 1 is a view explaining an electronic component in an embodiment of the present invention.

FIG. 1A is a perspective view of an electronic component in Embodiment 1 of the present invention, and FIGS. 1B and 1C are sectional views on predetermined portions (on planes shown by arrows 122A and 112B).

In FIG. 1, electronic component 201 has coil wirings 100 and external electrode section 102, which are covered by protecting section 104 made of a resin. Electronic component 201 further has vias 106a and 106b, projections 108, external electrode-via connecting section 110, and depressions 114. Here, the via means a hole filled with a conductive material. Further, a resin constituting the protecting section is required to have electrically insulating and shape-holding properties. For example, a cross-linked resin such as an epoxy resin, an unsaturated polyester resin or an acryl resin can be applied.

As thus described, electronic component 201 of Embodiment 1 is an electronic component having: protecting section 104 made of a resin; a coil section that includes coil wirings 100, vias 106a and the like which are formed inside protecting section 104; and external electrodes 102a and 102b parts of which are exposed from protecting section 104. In electronic component 201, projections 108 and external electrode-via connecting section 110 which function as an adhesion reinforcement structure, are formed on portions where external electrodes 102a and 102b are embedded in protecting section 104.

A further specific description is given below.

In FIG. 1A, coil wiring 100 constituting part of the coil section is formed in spiral shape, curved shape, or circular shape, and a plurality of coil wirings 100 are connected through vias 106a formed at predetermined positions, to form a three-dimensional coil pattern inside protecting section 104. One end of coil wirings 100 (right-side end surface of FIG. 1A) is connected to external electrode-via connecting section 110 through a plurality of vias 106a formed at positions on the substantially same straight line, so as to be connected to external electrode 102a.

Further, after coil wirings 100 and vias 106b have been alternatively connected to form the three-dimensional pattern, the other one end of the coil pattern (left-side end surface of FIG. 1A) is directly connected from the inside (protecting section 104 side) to the side surface of external electrode 102b. Moreover, the three-dimensional coil pattern formed of coil wirings 100 and vias 106b is covered by protecting section 104 for protection from the outside. Furthermore, projections 108 are formed for example in wedge shape on protecting section 104 side of external electrode 102, so that the bonding strengths of external electrodes 102a and 102b to protecting section 104 can be enhanced. For this reason, projections 108 are included in the adhesion reinforcement structure.

FIG. 1B is a sectional view of electronic component 201 in the state of having been cut along a plane including arrow 112A of FIG. 1A. As shown in FIG. 1B, a plurality of wedge-shaped projections 108 are formed on the plane in contact with protecting section 104 inside external electrode 102a, so as to enhance the connection strength. Further, external electrode-via connecting section 110 is provided with depressions 114, which enhance the strength against an external force of drawing. Therefore, depressions 114 are included in the adhesion reinforcement structure. It is to be noted that, as described later, forming these portions as an integral object can further enhance the strength.

Moreover, in FIG. 1B, a condition is shown where external electrode 102b is directly connected with inner coil wiring 100. Although the connection between external electrode 102b and inner coil wirings 100 is formed in the lowest layer of coil wirings 100 in Embodiment 1, it is not necessary that where to form the connection be particularly restricted to the lowest layer. In the case of directly connecting external electrode 102b with coil wirings 100 as shown in FIG. 1B, it is desirable to form the connection not on major side surface 201A but on minor side surface 201B or minor side surface 201C. In FIG. 1B, external electrode 102b is connected with coil wirings 100 on minor side surface 201B. In FIG. 1B, major side surface 201A is a side surface corresponding to a short side of electronic component 201, and minor side surface 201B is a side surface corresponding to a long side of electronic component 201. External electrodes 102a and 102b are formed throughout the short side, and partially on the long side.

Here, major side surface 201A is a portion where a major fillet (a portion to be soldered) is formed in solder mounting of the components. This major side surface 201A is a portion to which a tensile force and a compression force tend to apply after solder mounting. On the other hand, although fillets are formed on minor side surface 201B and minor side surface 201C by solder mounting, these are the surfaces to which almost no external force is applied. Since almost no external force is vectorially applied to minor side surface 201B and minor side surface 201C, even when the external force is applied to external electrode 102b, an influence of the external force on coil wirings 100 can be suppressed by connecting inner coil wirings 100 from the inside of minor side surface 201B or minor side surface 201C.

FIG. 1C is a sectional view in the case of cutting electronic component 201 along a plane including arrow 112B of FIG. 1A. As shown in FIG. 1C, a lower portion, namely a portion wet with solder or a portion exposed to the outside, of external electrode 102 has a simple configuration. With such a configuration formed, a mounting method, a mounting device, mounting member, and the like which are in broad use in typical chip component mounting can be converted as they are.

As thus described, electronic component 201 of Embodiment 1 is the same as a conventional chip component in terms of an exposed section (or outer appearance) of the electronic component, but has a characteristic in its inner structure (especially a junction between the conducting portion and the resin portion).

It is to be noted that in FIG. 1B, formation of external electrode 102b and coil wirings 100 on the same level as the same object or an integral object allows seamless connection therebetween so as to increase the strength and reduce the number of man-hours. Further, formation of external electrode 102a and external electrode-via connecting section 110 or the like on the same level as the same object (or an integral object) in the same manner as above makes it possible to increase the strength and reduce the number of man-hours.

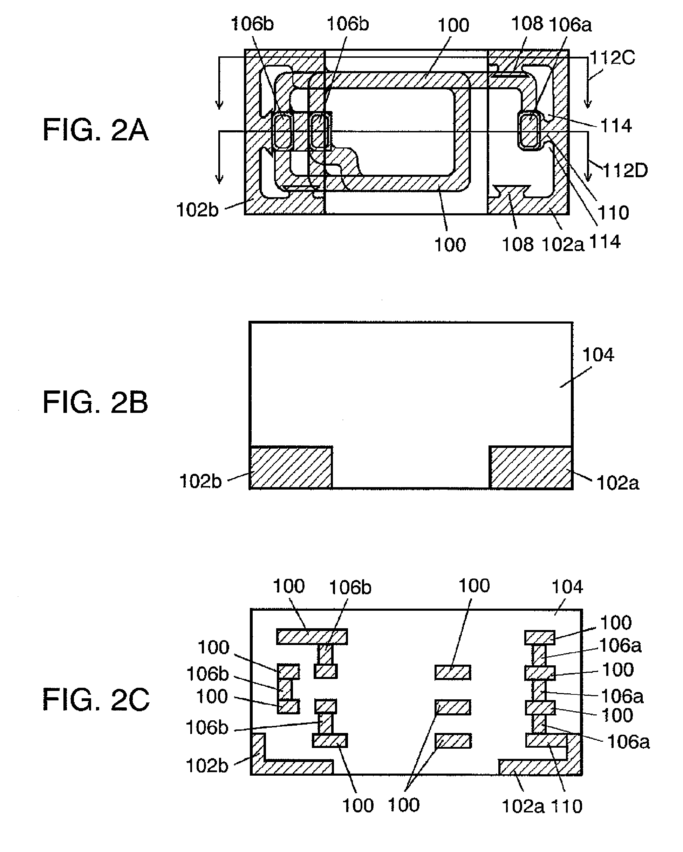

FIG. 2 is a view explaining the structure of electronic component 201 in Embodiment 1. FIG. 2A is a schematic view explaining a condition of electronic component 201 of FIG. 1 perspectively seen from its top surface.

It is found from FIG. 2A that a plurality of coil wirings 100 form the three-dimensional coil through vias 106b. One end of coil wirings 100 is connected to external electrode-via connecting section 110 through via 106a, and depressions 114 are provided between external electrode-via connecting section 110 and external electrode 102a. It is to be noted that as described in Embodiment 2, external electrode-via connecting section 110 and external electrode 102a may be formed simultaneously or as an integral object. Forming them as the integral object makes the problem of the strength less likely to occur even with depressions 114 formed between external electrode-via connecting section 110 and external electrode 102a.

FIG. 2B is a sectional view along arrow 112C of FIG. 2A. It is found from FIG. 2B that the side surface of the electronic component of Embodiment 1 has a simple structure made up of protecting section 104 and external electrodes 102a and 102b. With the outer structure, especially a section exposed to the outside, simplified as described above, a mounting method, a mounting device, a mounting member, and the like which are in broad use in typical chip component mounting can be converted as they are.

It is found from FIG. 2B and FIG. 1C that external electrodes 102a and 102b are formed on the bottom and the side surface. Since forming external electrodes 102a and 102b both on the bottom and the side surface as thus shown can lead to an increase in wet area with respect to solder or fillet formed portion so that the mounting strength can be enhanced. It is desirable as thus shown that the outer appearance of the electronic component be made substantially rectangular and that one external electrode be exposed from the resin on not less than one surface and not more than four surfaces of the substantially rectangular solid. It is to be noted that the rectangular solid has six surfaces in total. Here, when the number of exposed surfaces is one, the influence may be exerted on the mounting properties and mounting strength. Further, when the number of exposed surfaces is not smaller than five, the external electrode may become excessively large, to have an influence on characteristics of the coil or the like, or on size reduction.

FIG. 2C is a sectional view along arrow 112D of FIG. 2A. It is found from FIG. 2C that coil wirings 100 are two-dimensionally formed and coil wirings 100 each formed as a two-dimensional pattern are connected through vias 106b, to form the three-dimensional coil wirings.

It is to be noted that in FIG. 2C, right-side vias 106a and island-shaped coil wirings 100 are alternately superposed and connected, to change the thickness or the cross-sectional area of their connecting portions. Namely, coil wirings 100 are connected to external electrode-via connecting section 110 through the connecting portion whose thickness changes with respect to the connecting direction. That is, the configuration is formed such that coil wiring 100 having a larger area than via 106a is connected as superposed on via 106a, and on that coil wiring 100, another via 106a is further superposed for connection. This superposition can be formed of a desired number of steps. In addition, coil wiring 100 sandwiched between vias 106a may have a so-called island shape that is similar to the shape of via 106a and has an area made larger than that of via 106a. With such a configuration, via 106a can be resistant to falling off even when the tensile force is applied, thereby enhancing the strength.

It is to be noted that either shape may be formed: in FIG. 1A, a plurality of vias 106a are formed on the substantially same straight line to be connected to external electrode-via connecting section 110; or in FIG. 2C, vias 106a and coil wirings 100 are alternately formed to be connected to external electrode-via connecting section 110. Via 106a functions as the via so long as the size of coil wiring 100 is smaller than a fixed size.

Further, in FIG. 2C, coil wirings 100 in respective layers are formed as the three-dimensional coil pattern through left-side vias 106b. As shown in FIG. 2C, by formation of vias 106b so as to be alternately displaced by degrees, it is possible to gain the turning number, the turning angle, or the track length of the coil pattern per one plane. Further, for example, it is possible to increase the strength against the external force such as the tensile force.

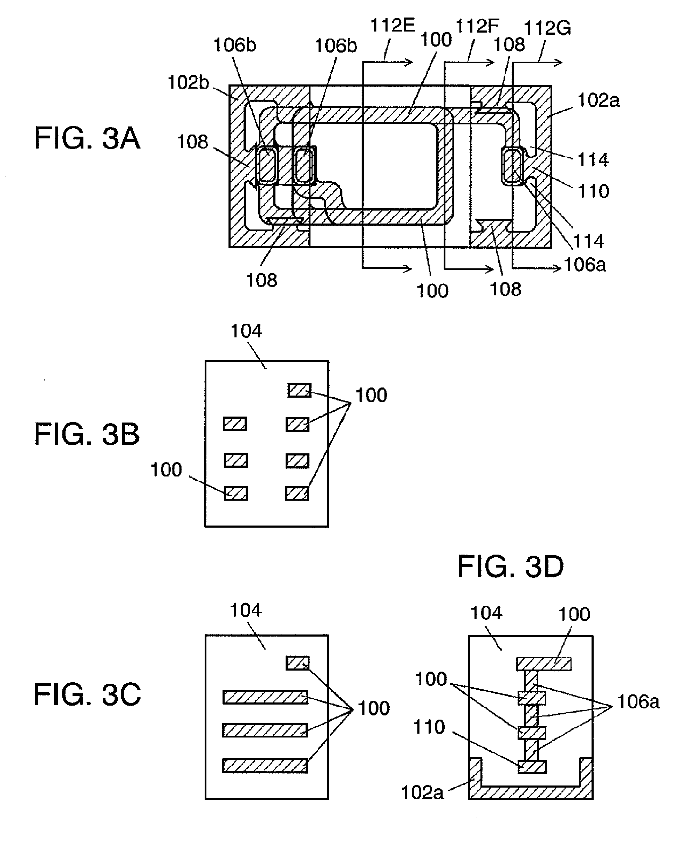

FIG. 3 is a schematic view specifically explaining Embodiment 1.

The sectional views along arrows 112E, 112F and 112G in FIG. 3A correspond to FIGS. 3B, 3C and 3D, respectively. It is found from FIGS. 3B and 3C that the central section of the coil in Embodiment 1 forms a simple three-dimensional coil pattern. By formation of such a simple coil pattern, excellent magnetic circuit characteristics can be obtained. Further, as shown in FIG. 3D, after vias 106a and coil wirings 100 have been alternately superposed in a plurality of numbers, one end of coil wirings 100 is connected to external electrode-via connecting section 110. As has been described, changing the respective thicknesses, the shapes or the cross sections of vias 106a and coil wirings 100 can enhance the strength against the tensile force.

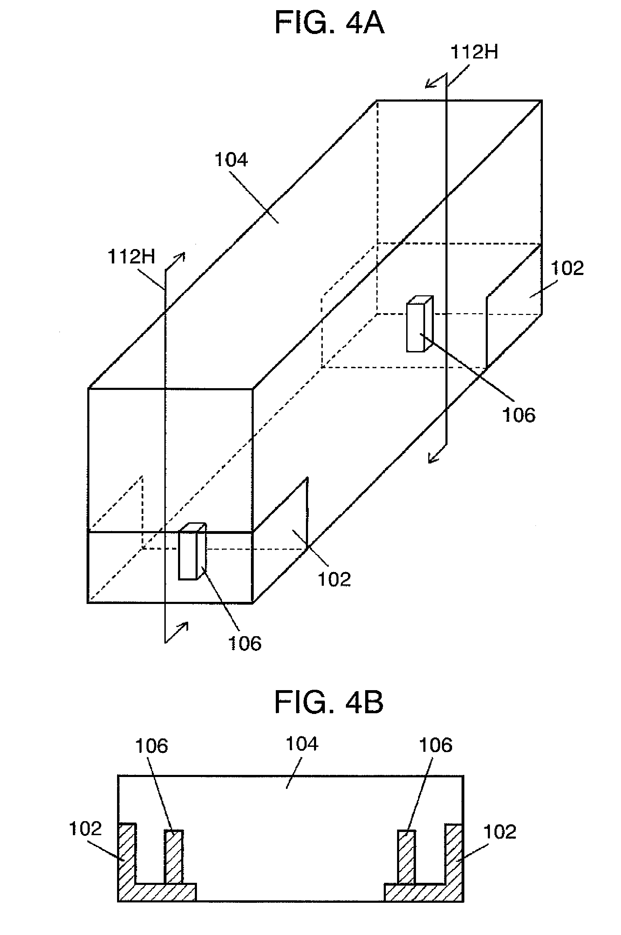

Embodiment 1 is further specifically described with reference to FIGS. 4 to 6.

FIG. 4A is a schematic view showing a condition in the case of not using the external electrode-via connecting section. FIG. 4B is a sectional view on a plane including arrow 112H of FIG. 4A. In FIG. 4, via 106 is formed directly on the bottom of external electrode 102. It is to be noted that in FIG. 4, a wiring pattern for forming a coil and the like is not shown.

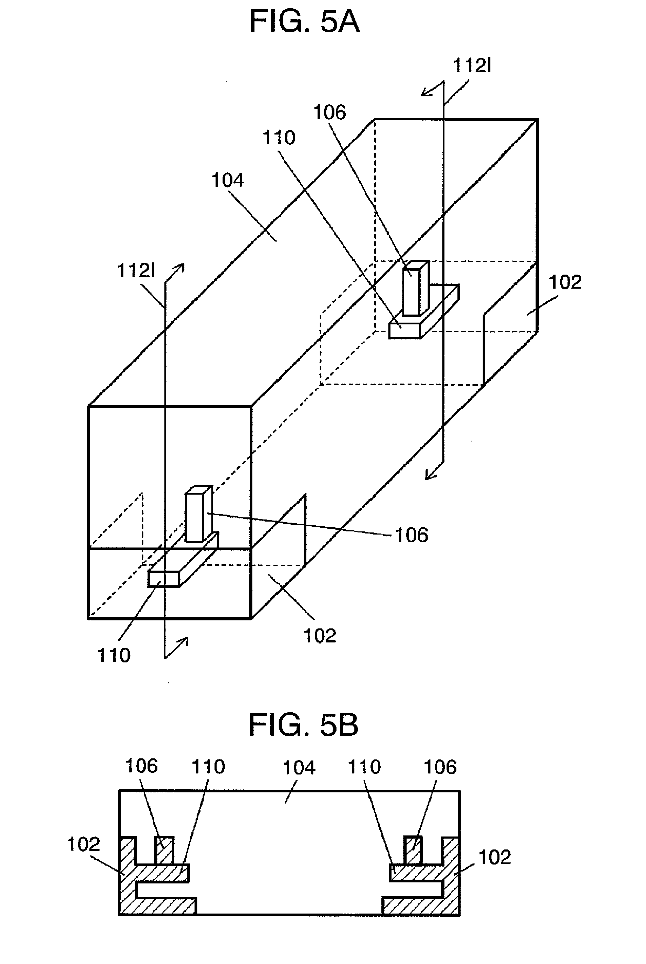

FIG. 5 is a schematic view showing the external electrode-via connecting section shown in FIGS. 1 to 3, and via 106 is connected to external electrode 102 through external electrode-via connecting section 110. It is to be noted that coil wirings 100 are omitted in FIG. 5. Further, FIG. 5B is a sectional view cut along a plane including arrow 112I of FIG. 5A.

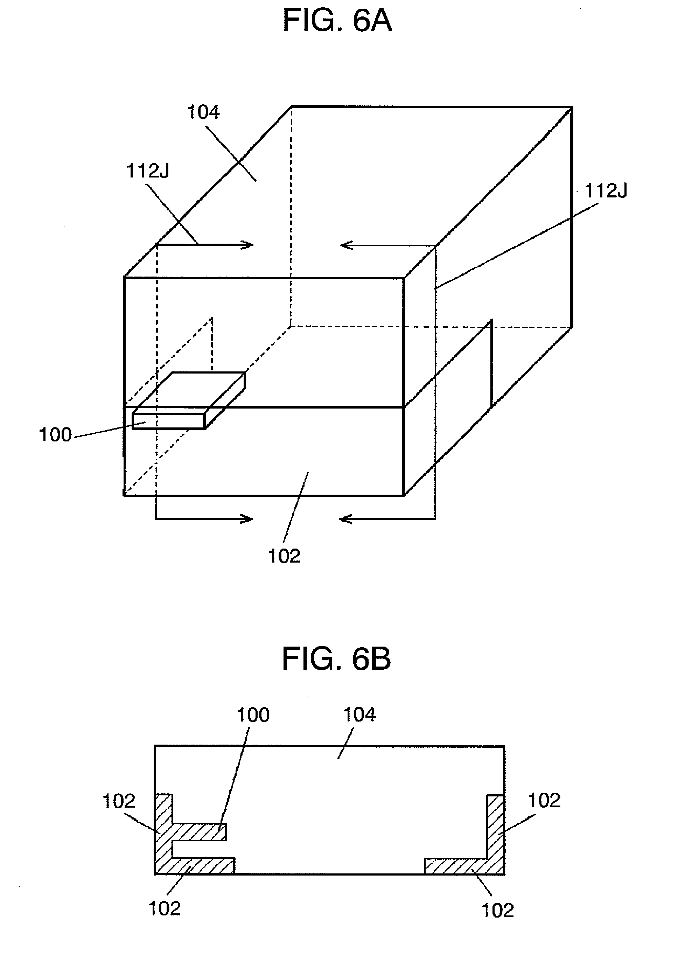

Moreover, FIG. 6 is a schematic view explaining a connecting position of the external electrode and wirings described with reference to explained in FIG. 1B, as well as a schematic view showing a condition where coil wiring 100 is directly connected to the minor side surface side of external electrode 102 of the electronic component. It is to be noted that another external electrode, wirings, vias and the like are omitted in FIG. 6. Further, FIG. 6B is a sectional view cut along a plane including arrow 112J of FIG. 6A.

Next, the strengths of these constitutional electronic components having the respective structures were measured.

First, FIGS. 4 and 5 were compared. Firstly, 100 units of samples were prototyped where via 106 is directly connected with external electrode 102 as shown in FIG. 4. These are samples formed by extending via 106 of FIG. 3D downward to be connected to external electrode 102a as it is. When the mounting strengths of the prototyped samples were measured, defects such as disconnection occurred with the strengths 30 to 50 % smaller than a required specification. Then the disconnected places were analyzed, to find that in many cases, peeling had occurred on the interface between via 106 and external electrode 102 or the like.

Next, when samples (n = 100 units) having a structure provided with external electrode-via connecting section 110 shown in FIG. 5 were prototyped and the mounting strengths thereof were observed in the same manner as above, a defect did not occur and a predetermined strength specification was satisfied. It is found that intervening external electrode-via connecting section 110 as shown in FIG. 5 enables external electrode-via connecting section 110 to function as a kind of buffers. It is found that, as thus described, an electronic component capable of obtaining a predetermined mounting strength can be manufactured with the use of external electrode-via connecting section 110, even without the use of substrate 2. Further, needless to say, not using substrate 2 permits further reduction in height of the component.

Moreover, FIG. 6 is an example of connecting coil wiring 100 to the minor side surface of external electrode 102. By connection of coil wiring 100 to the minor side surface of external electrode 102 as thus shown, it is possible to suppress an influence applied by the external force to the external electrode. Namely, with the structure of FIG. 6 formed, even when the external force is applied to external electrode 102 after soldering, the external force is mostly applied to external electrode 102 formed on the major side surface side, while having almost no influence on the minor side surface and coil wiring 100 connected to the minor side surface. As opposed to this, when the external force is applied in a distorted direction, the external force may also have an influence on the minor side surface, but in the case of an ultra-small electronic component as in the present invention, the distorted force does not apply as the external force in terms of a moment as well as a mounting structure.

As thus described, the mounting strength can be enhanced by formation of the adhesion reinforcement structure where coil wiring 100 is directly connected to the minor side surface of external electrode 102. Further, with no substrate is used, the component can be reduced in height. Moreover, external electrode-via connecting section 110 and external electrode 102 may be formed on the same level as an integral object.

### Embodiment 2

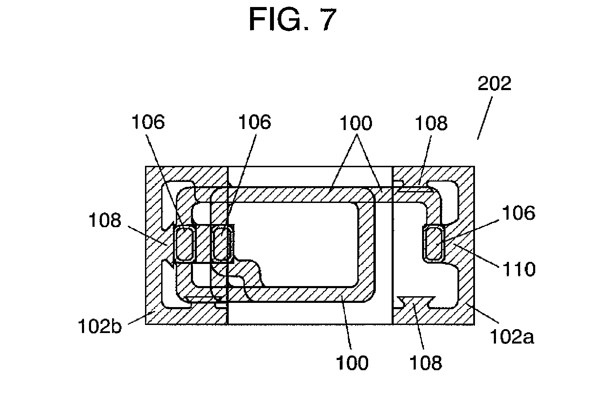

Next, Embodiment 2 is described with reference to drawings. FIG. 7 is a schematic view explaining electronic component 202 in Embodiment 2. Embodiment 1 and Embodiment 2 are different in presence or absence of depression 114. Depressions 114 provided in external electrode-via connecting section 110 in FIGS. 1B, 2A and 3A are not formed in electronic component 202 shown in FIG. 7. External electrode via connecting section 110 is formed substantially perpendicularly to external electrode 102a, and on the connecting portion, arcs are formed in place of depressions 114 of Embodiment 1. In addition, even if arcs are not formed, the contacting portion of external electrode-via connecting section 110 and external electrode 102a may preferably function so long as being smoothly curved with a predetermined curvature.

Setting a fixed curvature (R) to the connecting portion with external electrode 102a can enhance the connection strength with external electrode 102a. Forming the arcs or the like in such a manner can prevent stress concentration on the connecting portion of external electrode-via connecting section 110 and external electrode 102a, so as to enhance the cutting strength on these portions.

In present Embodiment 2, external electrode-via connecting section 110 is provided on the connecting portion of external electrode 102a and coil wirings 100, to make external electrode-via connecting section 110 have the adhesion reinforcement structure, thereby allowing reduction in height of the electronic component.

### Embodiment 3

In the following, an electronic component of the present invention is described as Embodiment 3 of the present invention with reference to drawings.

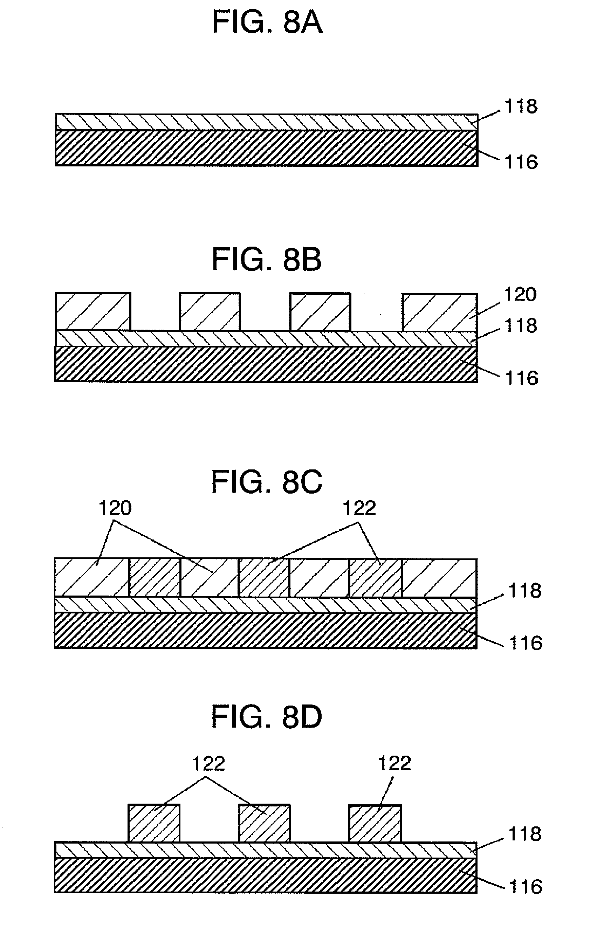

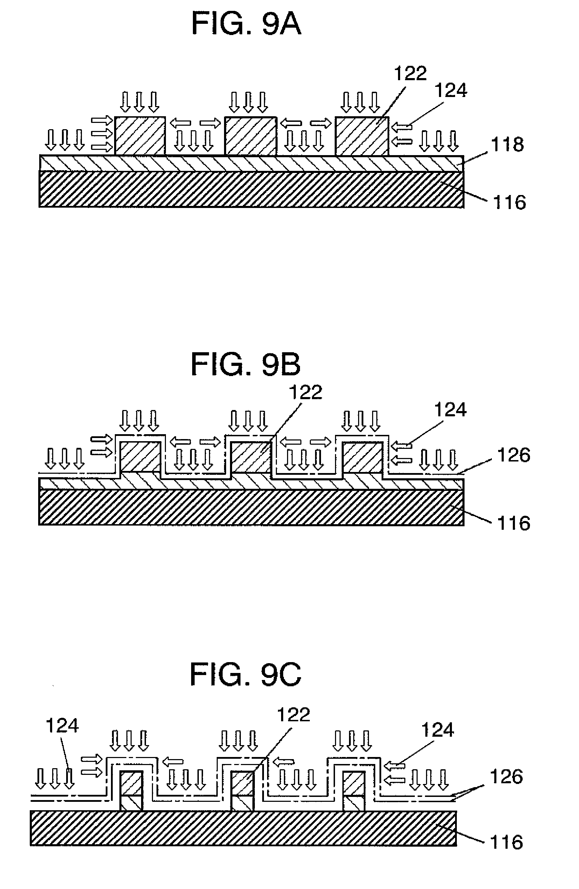

FIGS. 8 and 9 are sectional views explaining a production method of the present invention according to Embodiment 3, and the case of using a semi-additive method as a wiring production method is described. FIGS. 8 and 9 show substrate resin 116, plating electrode 118, resist pattern 120, and wirings 122.

In FIG. 8A, plating electrode 118 is formed on substrate resin 116 by means of a thin film method, electroless plating, or the like. Next, as shown in FIG. 8B, resist pattern 120 is formed on plating electrode 118 by photolithography. Further, as shown in FIG. 8C, wirings 122 are formed by electric plating at portions on plating electrode 118 where resist pattern 120 is not formed (portions where plating electrode 118 is exposed). Subsequently, resist pattern 120 is removed as shown in FIG. 8D. However, in the state of FIG. 8D, a plurality of wirings 122 are electrically connected to each other through plating electrode 118. Next, with reference to FIG. 9, a process for insulation between the wirings is described.

FIG. 9 is a sectional view explaining a condition of performing the process for insulation between a plurality of wirings.

As shown in FIG. 9A, firstly, the sample of FIG. 8D is soaked into a predetermined etching solution, to etch wirings 122 and plating electrode 118 by degrees in directions of outlined arrows 124. It is to be noted that the etching solution is not shown in FIG. 9A.

FIG. 9B shows a condition of wirings 122 and plating electrode 118 in the process of being etched. Dotted line 126 shows a state prior to etching. Namely, wirings 122 in FIG. 9A show the thickness of the substrate conducting film and the thickness prior to etching. It is to be noted that in the state of FIG. 9B, plating electrode 118 still remains between wirings 122, and the wirings 122 are not mutually insulated. FIG. 9C is a sectional view showing a state where the etching has been completed. Since no plating electrode 118 is left between a plurality of wirings 122, wirings 122 are mutually insulated.

### Embodiment 4

In the following, a manufacturing method of the present invention is described as Embodiment 4 of the present invention. In the case of the electronic component, a further higher characteristic, e.g. a high Q value (Quality factor), may be desired depending on application. Here, a Q value is desirably high. In such a case, the method of Embodiment 3 may not be sufficient. In the application like this, with the use of a wiring forming method described in Embodiment 4, the film thickness and the cross sectional area of wiring 122 can be increased, so as to enhance the characteristics of the electronic component.

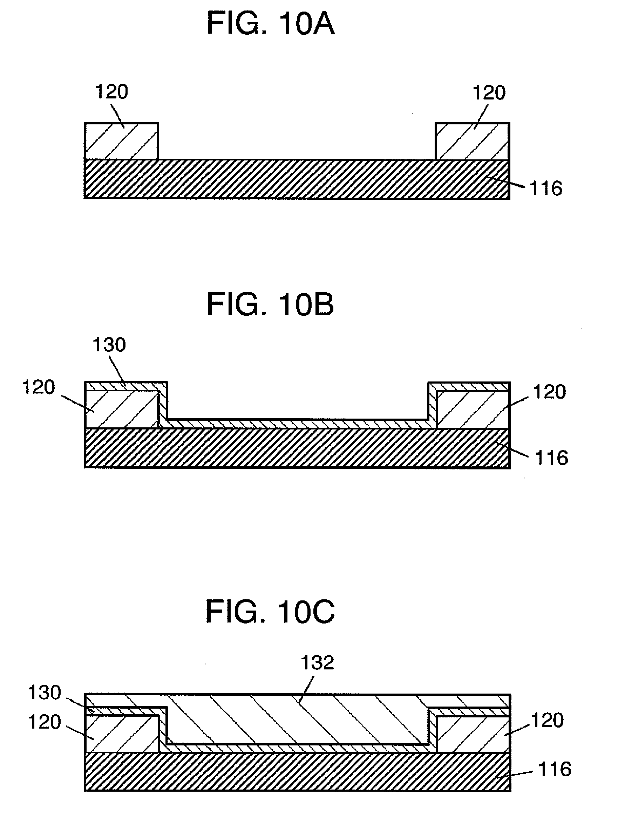

FIGS. 10 to 14 are sectional views explaining the method for manufacturing an electronic component according to the present invention. In FIGS. 10 to 14 shown are substrate resin 116, substrate electrode 130, metal 132, light 134, mask 136, light shielding section 138, uncured photosensitive resist 140, and hole 142.

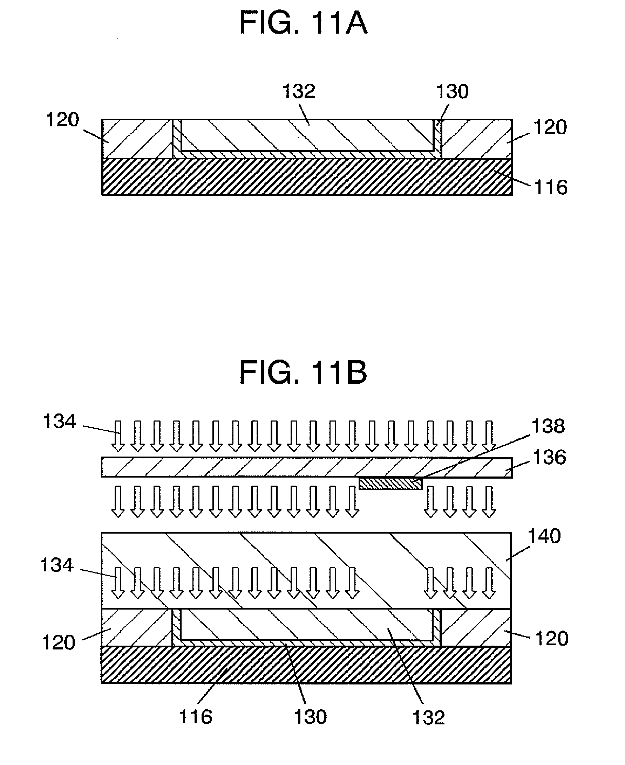

First, as shown in FIG. 10A, a predetermined pattern based on resist pattern 120 is formed on substrate resin 116. In this manner, a concave pattern is formed of a resin. Next, as shown in FIG. 10B, substrate electrode 130 is formed so as to cover substrate resin 116 and resist pattern 120. Then, as shown in FIG. 10C, metal 132 is formed by a method such as electric plating through the use of conductivity of substrate electrode 130. Subsequently, an extra portion of metal 132 is removed by polishing to form a shape as shown in FIG. 11A. After smoothing the surface as shown in FIG. 11A, uncured photosensitive resist 140 is applied with a predetermined thickness. It is to be noted that this process is omitted in the figure.

Next, as shown in FIG. 11B, uncured photosensitive resist 140 is exposed. In FIG. 11B, uncured photosensitive resist 140 is formed on resist pattern 120, substrate electrode 130, and metal 132. Light 134 is applied from an exposing device (not shown in FIG. 11) to uncured photosensitive resist 140 through mask 136, to cure uncured photosensitive resist 140. Applied light 134 is shown with outlined arrows. At this time, since light 134 is not applied to a portion of uncured photosensitive resist 140 where light is shielded by light shielding section 138 of mask 136, this portion is left in the uncured state.

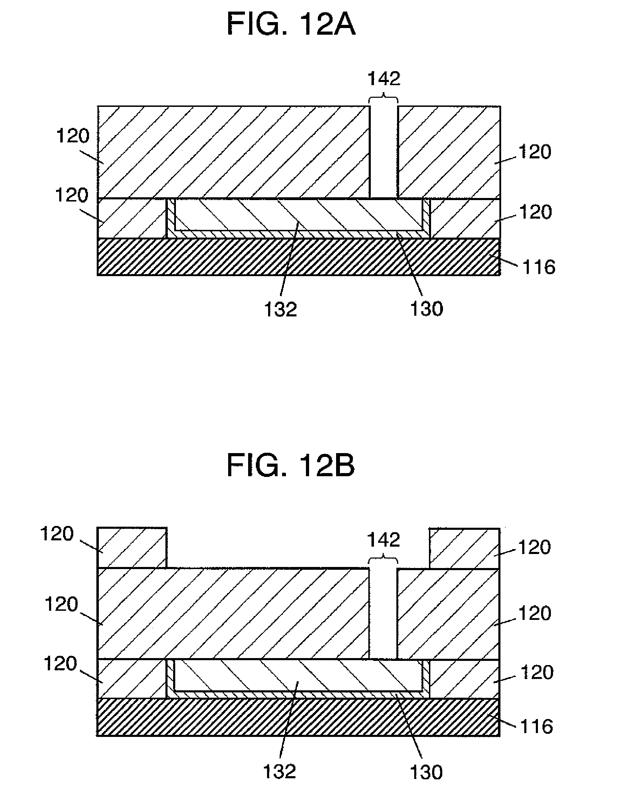

Next, a photosensitive resin is subjected to a development process, to form a state of FIG. 12A. Here, exposed uncured photosensitive resist 140 in FIG. 11B is cured, to become resist pattern 120 in FIG. 12A. Meanwhile, the uncured photosensitive resin at the portion of light shielding section 138 is removed, to form hole142 in FIG. 12A. By repeatedly performing the application, exposure and development processes on the photosensitive resin in the manners as thus described a plurality of times, a shape as shown in FIG. 12B is formed.

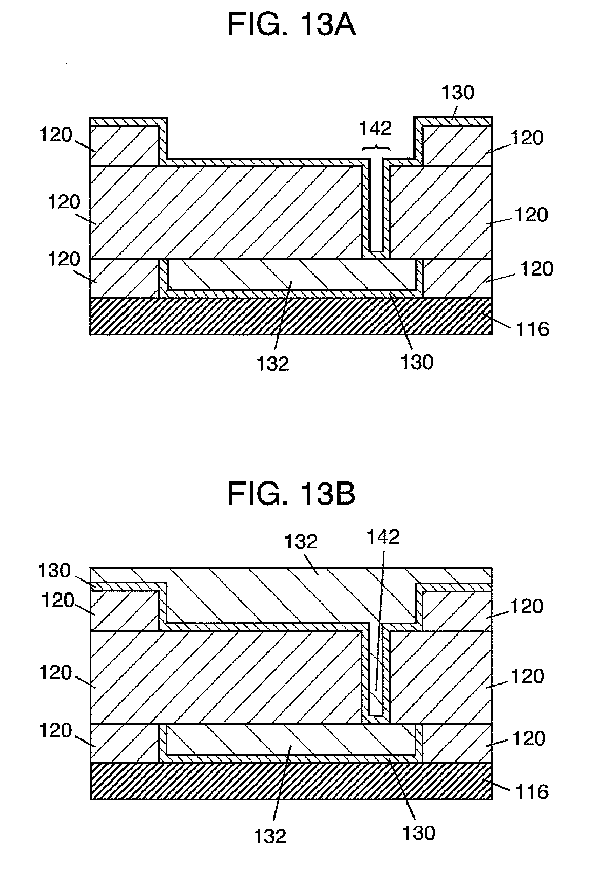

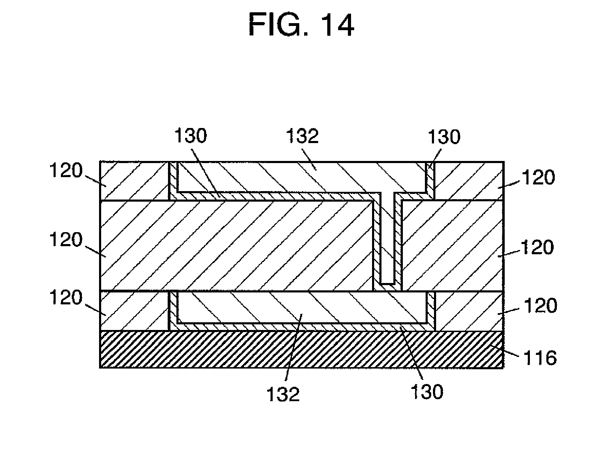

Next, as shown in FIG. 13A, substrate electrode 130 is formed so as to cover or fill resist pattern 120 and hole 142, and through the use of conductivity of substrate electrode 130, metal 132 is deposited as shown in FIG. 13B. Then, extra metal 132 is removed by polishing or the like, to allow formation of a shape as shown in FIG. 14.

In such a manner, repetition of the steps explained in FIGS. 10 to 14 necessary times can lead to manufacturing of the electronic component as shown in FIG.1. It is to be noted that the photo-sensitive resin may be used as substrate resin 116. With the use of the photosensitive resin as thus described, an electronic component where wirings are three-dimensionally formed without the use of a substrate such as an alumina substrate can be formed. Further, coil wirings 100, external electrode 102 and vias 106 in FIG. 1 can be collectively formed.

In addition, as substrate electrode 130, a metal such as nickel, copper, chrome, titanium, or silver, or an alloy material of those metals is desirably selected. Further, on this selected material, copper is desirably deposited by electric plating. It is to be noted that the film thickness of substrate electrode 130 is desirably larger than 0.01 µm and smaller than 5 µm. In the case of the thickness below 0.01 µm, electric plating may not be easy to perform. Further, in the case of the thickness over 5 µm, formation cost increases and inner stress of the substrate electrode increases, which may cause rolling-up, peeling or breaking of the substrate electrode. It is to be noted that the thickness is desirably not smaller than 0.05 µm and not larger than 1 µm, considering the process management. As the method for forming substrate electrode 130 as thus described, a plating method including electroless plating and a method for forming a thin film including sputtering and electron beam vapor deposition can be selected.

In the case of using different metallic elements for substrate electrode 130 and metal 132, analysis is easily performed by embedding the completed sample in a resin and analyzing its cross section by an X-ray micro-analyzer (XMA) or the like. Further, in the case of using the same metallic element (e.g. copper) for substrate electrode 130 and metal 132, it may be difficult to analyze the presence or absence of substrate electrode 130 only by the XMA.

In such a case, with the use of a chemical analysis technique, the presence or absence of substrate electrode 130 can be determined. For example, it can be easily determined by etching the surface of the sample by an etching solution made of hydrogen peroxide (H₂O₂) and sulfuric acid (H₂SO₄), and then observing how the surface is etched, namely a fine structure of the etched surface, using an electron microscope or the like. Especially in the case of the present invention, making the wirings substantially rectangular due to its manufacturing method, a resistance value of the wirings can be lowered in a limited volume. Further, since substrate electrode 130 is not formed on one surface (i.e. the surface where hole 142 as the via was formed as explained in FIGS. 10, 11 and the like), analysis can be easily performed by using such a chemical technique. It is to be noted that substrate electrode 130 is formed on the remaining three surfaces to form a metal multilayer structure.

### Embodiment 5

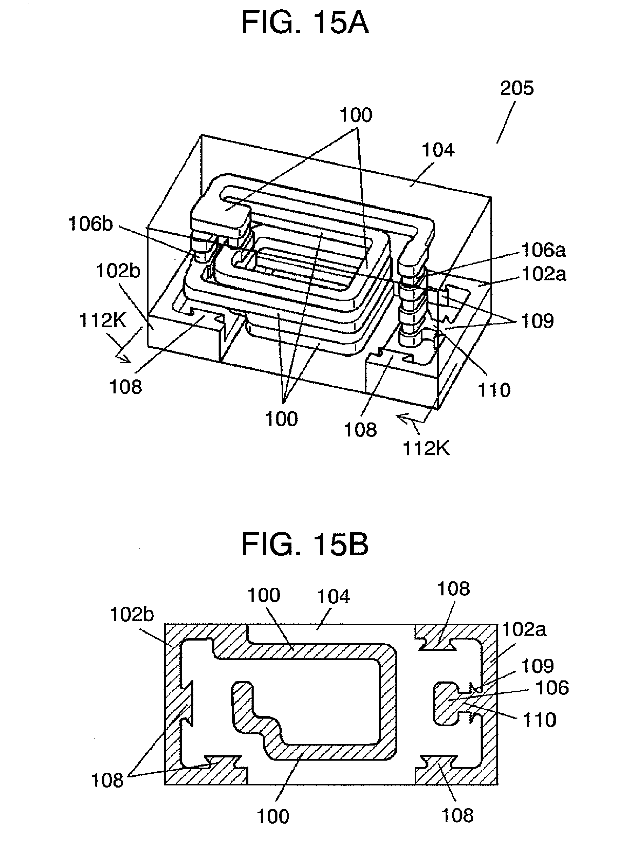

In the following, a structure of an electronic component in Embodiment 5 of the present invention is described with reference to drawings. FIGS. 15 to 17 are schematic views explaining Embodiment 5.

FIG. 15A is a perspective view of electronic component 205 in Embodiment 5 of the present invention, FIG. 15B is a sectional view on a predetermined portion (plane including arrow 112K). A sectional view on a plane including arrow 112K in FIG. 15A corresponds to FIG. 15B.

In FIG. 15A, coil wirings 100 are formed in spiral (or curved) shape and form a three-dimensional coil pattern through vias 106 (106a and 106b) formed at predetermined positions. One end (right side of FIG. 15A) of coil wirings 100 is connected to external electrode-via connecting section 110 through a plurality of vias 106a formed in layers, to be connected to external electrode 102a. Further, after coil wirings 100 and vias 106b have been alternately connected to form the three-dimensional coil pattern, the other end (left side of FIG. 15A) of the coil pattern is integrally formed with external electrode 102b. Further, the three-dimensional coil pattern formed of coil wirings 100 and vias 106 is covered by protecting section 104 for protection from the outside. Moreover, projections 109 are formed on external electrode-via connecting section 110 to enhance the bonding strength of protecting section 104, as are projections 108 provided on protecting section 104 side of external electrode 102. These projections 108 and 109 or external electrode-via connecting section 110 function as the adhesion reinforcement structure of the present invention.

FIG. 15B is a sectional view on the plane including arrow 112K of FIG. 15A. According to FIG. 15B, on the connecting portion of external electrode-via connecting section 110 and external electrode 102a, projections 109 are formed in place of depressions 114 of FIG. 1. By forming projections 109 on external electrode-via connecting section 110 as the connecting portion of external electrode 102a and via 106a, it is possible to suppress the influence on external electrode-via connecting section 110 and the like in a case where the tensile force or the like is applied through external electrode 102a.

Further, in FIG. 15B, a plurality of wedge-shaped projections 108 are formed on the plane in contact with protecting section 104 inside external electrode 102a, so as to enhance the connection strength.

It is to be noted that, although a projection or depression is not particularly provided between external electrode 102b and coil wirings 100 in FIG. 15B, a projection or depression may be formed according to need. For example, a projection may be formed on the side, closer to external electrode 102b, of coil wirings 100 connected with external electrode 102b of FIG. 15B. With the use of the adhesion reinforcement structure as thus described, it is possible to make the strength high in mounting of the electronic component. It is to be noted that the adhesion reinforcement structure is a physical structure typified by a wedge shape, depressions, concavity/convexity, an S-shape, and the like.

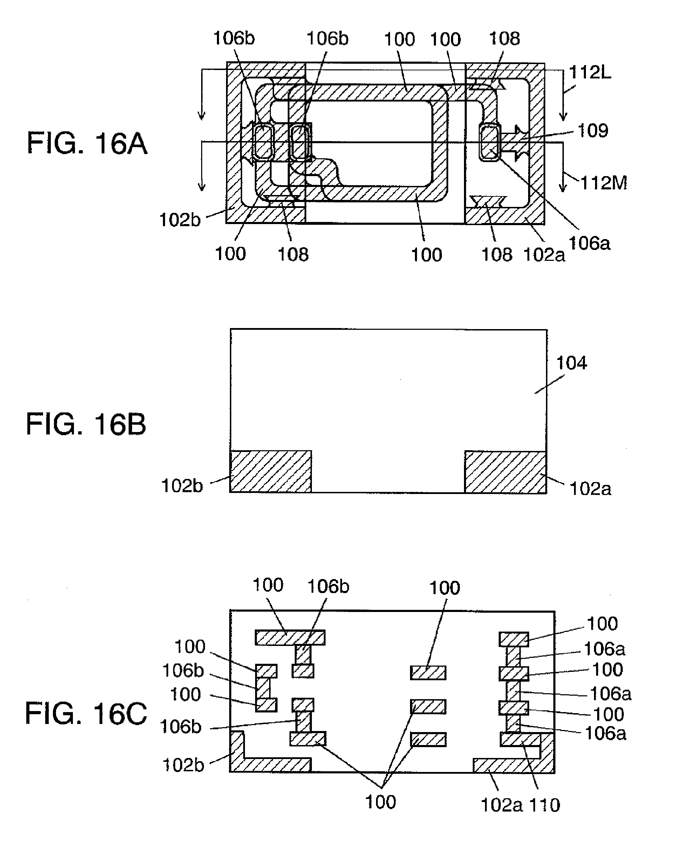

FIGS. 16A to 16C are sectional views of electronic component 205 in Embodiment 5 from other directions. FIG. 16A is a schematic view showing a condition where the electronic component of FIG. 15 is perspectively seen from the above. Further, the sectional views along arrows 112L and 112M of FIG. 16A correspond to FIGS. 16B and 16C.

FIG. 16B is a sectional view along arrow 112L of FIG. 16A. It is found from FIG. 16B that the side surface of the electronic component of Embodiment 5 has a simple structure formed of protecting section 104 and external electrode 102. With the outer structure simplified as thus described, a mounting method, a mounting device, mounting member, and the like which are in broad use in typical chip component mounting can be converted as they are.

Further, FIG. 16C is a sectional view along arrow 112M of FIG. 16A. In FIG. 16C, coil wirings 100 in respective layers form the three-dimensional coil pattern through the left-side vias 106b. Here, vias 106b are formed at alternately displaced positions. Alternately displacing the forming positions of vias 106b in this manner allows formation of not less than one turn of the coil in one layer so that the turning number can be gained. Further, displacing the forming positions of vias 106b allows reduction in influence of the external force from external electrode 102b, and changing the positions of vias 106b can prevent vias 106b and the like from fully falling off.

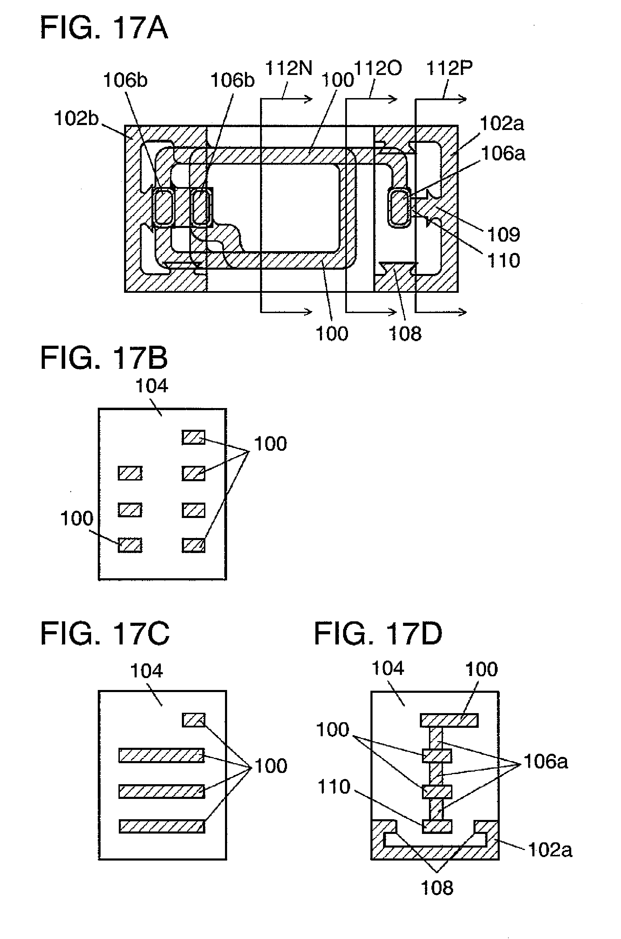

Further, the structure of the electronic component in Embodiment 5 is described with reference to FIG. 17. FIG. 17A is a schematic view perspectively explaining the sample of FIG. 15 from its top surface. Cross sections along arrows 112N, 112O and 112P of FIG. 17A are respectively shown in FIGS. 17B, 17C and 17D.

As shown in FIG. 17A, by formation of projections 109 near the connecting portion of external electrode-via connecting section 110 and external electrode 102a, it is possible to suppress the influence on external electrode-via connecting section 110 in the case of application of the external force.

### Embodiment 6

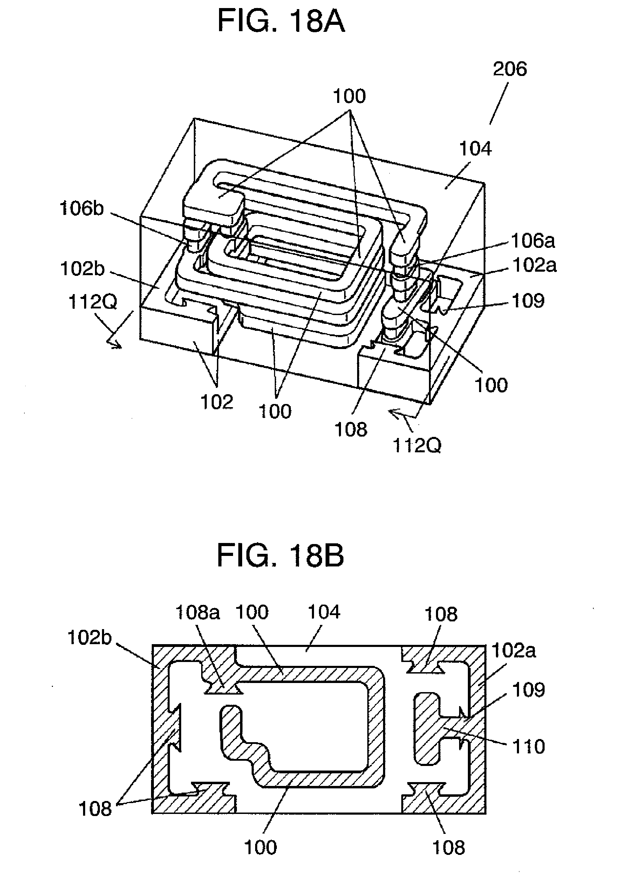

In the following, a structure of an electronic component in Embodiment 6 of the present invention is described with reference to drawings. FIGS. 18 to 20 are schematic views explaining Embodiment 6.

FIG. 18A is a perspective view of electronic component 206 in Embodiment 6 of the present invention, FIG. 18B is a sectional view thereof, and a sectional view along arrow 112Q of FIG. 18A corresponds to FIG. 18B.

In FIGS. 18A and 18B, coil wirings 100 are formed in spiral (or curved) shape, and form a three-dimensional coil pattern through vias 106 formed at predetermined positions. Projections 108a are formed in the vicinity of the connecting portion of coil wirings 100 and external electrode 102, to have an adhesion reinforcement structure to protecting section 104 of coil wirings 100.

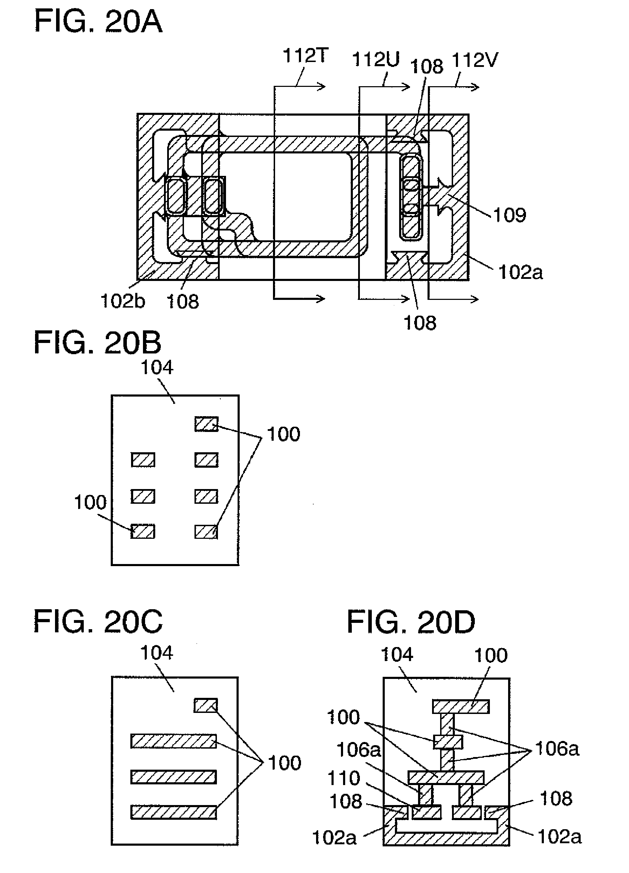

After coil wiring 100 and vias 106a have been alternately laminated, one end (right side of FIG. 18A) of the coil wirings 100 is connected to external electrode-via connecting section 110 integrally formed with external electrode 102a. External electrode-via connecting section 110 is then connected to external electrode 102a in the state of being integrally formed therewith. Further, projections 109 are formed between external electrode-via connecting section 110 and external electrode 102a, whereby, even when external electrode 102a is strongly pulled by the external force, the power can be dispersed to projections 109 so as to prevent damage occurrence such as interface peeling. Moreover, vias 106 and external electrode-via connecting section 110 are connected at a plurality of places (this is explained again in later-described FIG. 20), thereby exerting the effect of enhancing reliability of connection between via 106a and external electrode-via connecting section 110.

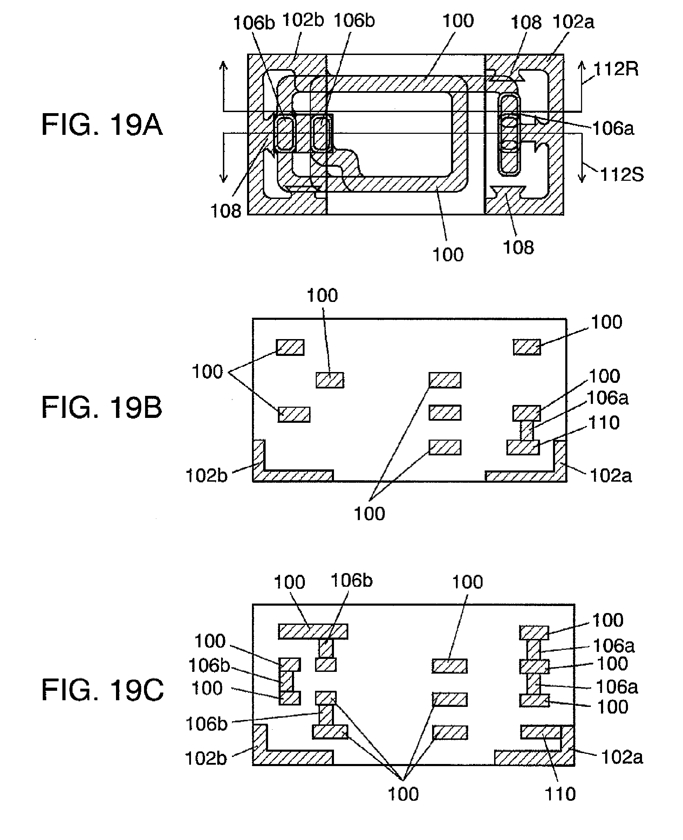

Further, a more specific description is given with reference to FIG. 19. FIGS. 19A to 19C are sectional views of the electronic component in Embodiment 6 from other directions. FIG. 19A is a schematic view of the electronic component of FIG. 18A perspectively seen from the above. Sectional views along arrows 112R and 112S of FIG. 19A correspond to FIG. 19B and 19C.

As shown in FIG. 19B and 19C, external electrode-via connecting section 110 formed on external electrode 102a side is connected to coil wirings 100 through a plurality of vias 106a formed in parallel. The condition of this parallel connection is described in details with reference to FIG. 20.

FIG. 20A is a schematic view explaining a condition of the sample of FIG. 18 perspectively seen from its top surface. Sectional views along arrows 112T, 112U and 112V are respectively shown in FIGS. 20B, 20C and 20D. In FIG. 20D, the end of coil wirings 100 having formed the three-dimensional coil pattern is connected to via 106a. After successive lamination of via 106a, coil wiring 100, via 106a and coil wiring 100, this lamination is branched into two through coil wiring 100, to be connected to a plurality of vias 106. Here, coil wiring 100 desirably has an island-shaped independent pattern. These plurality of vias 106a are then connected with external electrode-via connecting section 110 at a plurality of places. This external electrode-via connecting section 110 is then connected with external electrode 102a as an integral object. By connection of external electrode-via connecting section 110 with vias 106a at a plurality of places in this manner, the stability of the connection can be enhanced.

### Embodiment 7

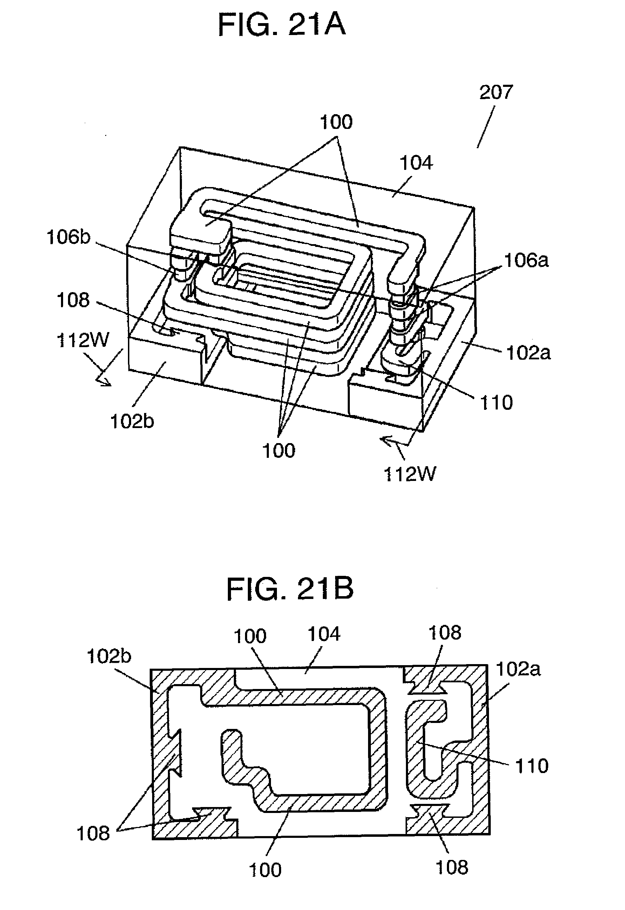

In the following, a structure of electronic component 207 in Embodiment 7 of the present invention is described with reference to drawings. FIGS. 21 to 23 are schematic views explaining Embodiment 7.

FIG. 21A is a perspective view of electronic component 207, and FIG. 21B is a sectional view on a predetermined portion. In FIG. 21A, a sectional view of a plane including arrow 112W corresponds to FIG. 21B.

In FIG. 21A, coil wirings 100 are formed in a spiral (or curved) shape, and form a three-dimensional coil pattern through vias 106 formed at predetermined positions. One end (right side of FIG. 21A) of coil wirings 100 is connected to external electrode-via connecting section 110 through a plurality of vias 106a formed in layers, to be connected to external electrode 102a. Further, after coil wirings 100 and vias 106b have been alternately connected to form the three-dimensional coil pattern, the other end (left side of FIG. 21A) of the coil pattern is directly connected to external electrode 102b in the lowest layer of the wiring portion of FIG. 21B. Moreover, the three-dimensional coil pattern formed of coil wirings 100 and vias 106 as a whole is covered by protecting section 104 for protection. Furthermore, projection 108 is a wedge-shaped one provided on protecting section 104 side of external electrode 102, to be aimed at enhancing the bonding strength of external electrode 102 and protecting section 104.

FIG. 21B is a sectional view on a plane including arrow 112W of FIG. 21A. FIG. 21B shows that external electrode-via connecting section 110 is bent in S-shape. By bending external electrode-via connecting section 110 in this manner, damage in the case of application of the external force can be suppressed. External electrode via connecting section 110 in such a shape is included in the adhesion reinforcement structure of the present invention.

Further, as shown in FIG. 21B, electronic component 207 has the adhesion reinforcement structure typified by a plurality of wedge-shaped projections 108 and the like also on the plane in contact with protecting section 104 inside external electrode 102a, to enhance adherence or bonding strength.

Making the track length of external electrode-via connecting section 110 larger as thus described can enhance resistance force against the tensile force. Further, according to need, projection 109 or depression 114 may be formed on external electrode-via connecting section 110, or external electrode-via connecting section 110 may be formed into two-branched shape (FIG. 20D etc.). In such manners, the resistance force against the external force can be enhanced. It is to be noted that even if external electrode-via connecting section 110 or the like is made to have a complicated pattern, since external electrode-via connecting section 110 can be formed integrally with external electrode 102a and the like, a problem in manufacturing is not apt to occur. Further, seamless integral formation of the conductor section made of a metal can ensure a sufficient strength against the external force.

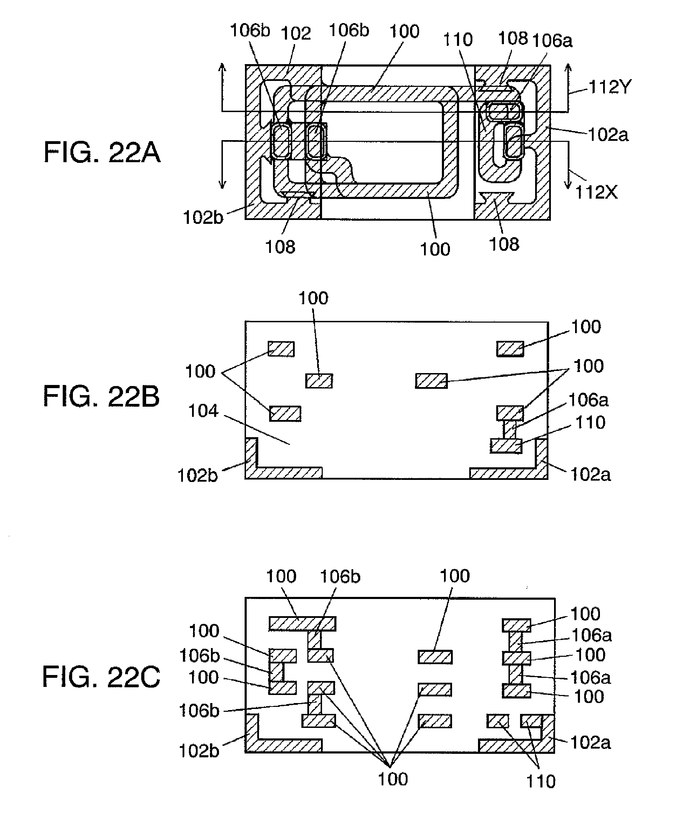

Further, a specific description is given with reference to FIG. 22. FIGS. 22A to 22C are sectional views of the electronic component in Embodiment 4 seen from different directions. FIG. 22A is a schematic view of an electronic component of FIG. 21A perspectively seen from the above. Moreover, sectional views along arrows 112X and 112Y of FIG.22A correspond to FIGS. 22B and 22C.

According to FIG. 22B, bent external electrode-via connecting section 110 formed on external electrode 102a side is connected to coil wiring 100 through via 106a. Further, according to FIG. 22C, external electrode-via connecting section 110 formed on external electrode 102a side is connected to coil wiring 100 through via 106a, which is connected to via 106b, and this via 106b is then connected to coil wiring 100. This coil wiring 100 is then combined with via 106b to form a predetermined three-dimensional coil pattern, which is connected to external electrode 102b. In Embodiment 7, by bending external electrode-via connecting section 110 in this manner, the track length of external electrode-via connecting section 110 can be made so large as to reach the connecting portion of external electrode 102a and via 106, thereby reducing stress concentration against the external force.

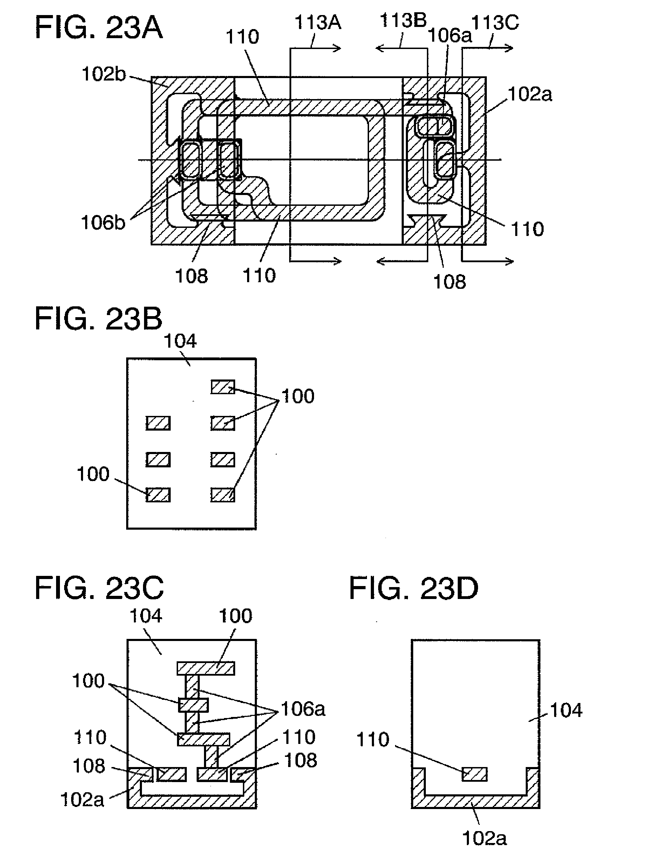

Moreover, FIG. 23A is a schematic view explaining a condition of the sample of FIG. 21 perspectively seen from its top surface. Sectional views along arrows 113A, 113B and 113C of FIG. 23A are respectively shown in FIGS. 23B, 23C and 23D. It is found from FIGS. 23C and 23D that external electrode-via connecting section 110 draws an S-shape. Using such structure can enhance the terminal strength of the electronic component. Therefore, external electrode-via connecting section 110 having such a shape is included in the adhesion reinforcement structure of the present invention.

### Embodiment 8

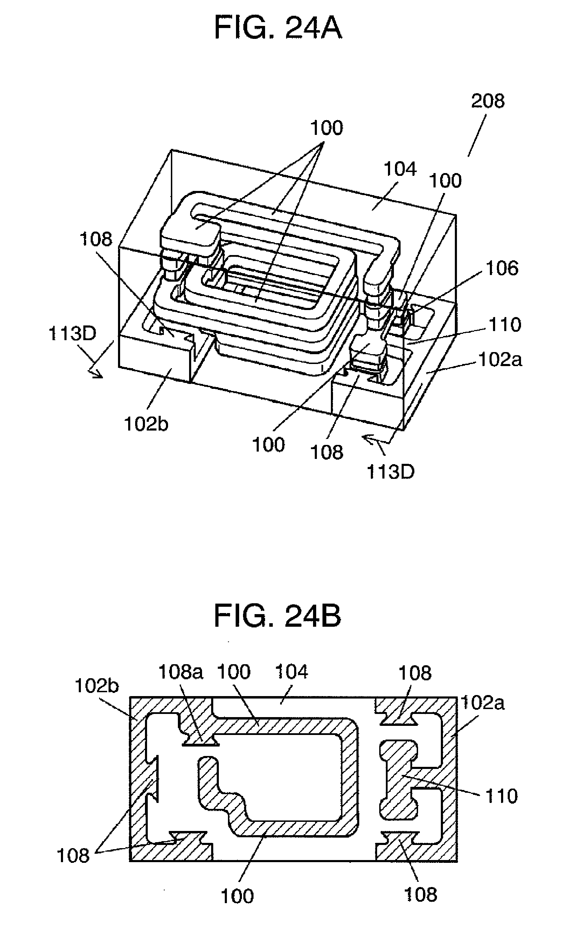

In the following, a structure of electronic component 208 in Embodiment 8 is described with reference to drawings. FIGS. 24 and 25 are schematic views explaining Embodiment 8.

FIG. 24A is a perspective view of electronic component 208 in Embodiment 8, and FIG. 24B is a sectional view of a predetermined portion. In FIG. 24A, the sectional view on a plane including arrow 113D corresponds to FIG. 24B.

In Embodiment 8, external electrode-via connecting section 110 is connected with coil wirings 100 at a plurality of places, and further, the via connecting section of the external electrode-via connecting section is made thick (or formed into a projected or substantially spherical shape), to stabilize the via connection. Here, FIGS. 24 and 25 are different in shape of external electrode-via connecting section 110 and directions of a plurality of vias 106. It goes without saying that devising the shapes of external electrode-via connecting section 110 and via 106 allows external electrode-via connecting section 110 and via 106 to correspond to the electronic component in a variety of forms.

As thus described, by formation of the adhesion reinforcement structure embedded in protecting section 104 in the electronic component formed of protecting section 104 made of a resin, coil wirings 100 formed inside protecting section 104, and external electrode 102 partially exposed from protecting section 104, a substrate having been a constitutional element of the conventional electronic component can be removed, thereby reducing the height of the electronic component.

As the adhesion reinforcement structure, projection 108 may be formed in external electrode 102 at the portion embedded in protecting section 104, or projection 108a may be formed at the portion where coil wiring 100 is embedded in protecting section 104.

Further, coil wirings 100 may be configured to be connected to the external electrode through external electrode-via connecting section 110 inside protecting section 104.

It is to be noted that the adhesion reinforcement structure can be formed in the external electrode-via connecting section or the connecting portion of the external electrode-via connecting section and the external electrode.

Further, coil wirings 100 can be a three-dimensional coil obtained by electrically connecting a plurality of coil wirings 100 formed in different layers through a plurality of vias 106.

Further, the outer appearance of the electronic component is a substantially rectangular solid, and the external electrode is exposed from the protecting section on not less than two surfaces and not more than four surfaces of the substantially rectangular solid, whereby the same mounting equipment can be used as in the case of the conventional electronic component.

Further, the coil section formed inside protecting section 104 is characterized to be connected with the minor side surface of the external electrode inside protecting section 104, whereby the external force applied to the external electrode can be suppressed from being transmitted to the coil section.

Further, at least part of the external electrode and part of coil wirings 100 to become the coil are formed on the same level, whereby external electrode 102 and coil wirings 100 can be manufactured collectively (further, as an integral object).

Further, in the three-dimensional coil formed of a plurality of coil wirings 100 and a plurality of vias 106 which are formed inside protecting section 104, one end of coil wirings 100 forming the coil is connected to the first external electrode through via 106 and the external electrode-via connecting section, and the remaining one end of coil wirings 100 is connected to the minor side surface of the second external electrode, whereby the three-dimensional coil having a complicated shape can be dealt with.

Further, the three-dimensional coil is formed such that coil wirings 100 are alternately displaced in the formation positions in the plane direction of the electronic component, whereby the external force can be suppressed from being transmitted to coil wirings 100 through vias 106 portions.

Further, in the coil section, a plurality of vias 106 are connected to coil wirings 100 on the substantially same perpendicular straight line, namely at the substantially same position in the plane direction. And the coil section is three-dimensionally formed using a plurality of vias 106 such that at least adjacent vias 106 have different sizes, diameters or shapes, whereby the external force can be suppressed from being transmitted to coil wirings 100 through vias 106.

Coil wiring 100 is branched into a plurality of numbers inside the resin, and the substantially ends of the branched wiring are respectively connected to external electrode-via connecting section 110 through a plurality of vias 106, whereby the external force can be suppressed from being transmitted to coil wirings 100 through the portions of vias 106. For example, in FIG. 20D, coil wiring 100 is branched to vias 106a.

Coil wiring 100 partly may have a curved section. The curved section in the state of being curved at an angle not smaller than 30 degrees or not less than half a turn is formed with external electrode 102 on the same level as an integral object, whereby the external force can be suppressed from being directly transmitted to wirings 100. It is to be noted that the curved state of the curved section includes a bent state.

The adhesion reinforcement structure is projection 108 or depression 114, and not less than one is formed or it is formed at not less than one place, whereby the external force can be dispersed all over protecting section 104 due to the adhesion reinforcement structure. With such an adhesion reinforcement structure, it is possible to obtain strengthened physical adhesion (e.g. a biting effect due to a wedge shape typified by projection 108), an anchor effect due to an increase in contact area of the protecting layer made of a resin, external electrode 102, the external electrode-via connecting section, etc., and some other effects.

The resin is preferably a photosensitive resin, and coil wiring 100 is a metal mainly made of copper formed by plating, whereby a resistance value of coil wiring 100 can be lowered so as to improve characteristics of the electronic component.

Among the surfaces where coil wirings 100 are in contact with protecting section 104, surfaces other than one surface connected with via 106 have a plurality of metal layers, whereby the characteristics of the electronic component can be improved.

The cross section of coil wiring 100 is formed in substantially rectangular shape, whereby the resistance value of coil wirings 100 can be suppressed within a limited area.

External electrode via connecting section 110 and part of external electrode 102 are formed on the same level as an integral object, whereby the connection between external electrode-via connecting section 110 and external electrode 102 can be stabilized.

The adhesion reinforcement structure made up of not less than one projection 108 or depression 114 at not less than one place is formed in external electrode-via connecting section 110, whereby the external force can be dispersed all over protecting section 104 through the external electrode-via connecting section and further the adhesion prevention structure.

The process of forming a predetermined concave portion using a photosensitive resin, the process of covering a portion above the concave portion by a metal, and the process of removing an unnecessary portion of the metal are repeated in a predetermined number, whereby protecting section 104 made of a photosensitive resin, external electrode 102 and coil wirings 100 can be integrally formed, so as to manufacture a highly accurate electronic component at low cost.

### INDUSTRIAL APPLICABILITY

As described above, according to the electronic component and the production method thereof in accordance with the present invention, the height thereof can be reduced due to nonuse of a substrate, and application to a component such as a coil or an inductor is possible since the cross sectional area can be increased even in forming further fine wirings, and further, the connection strength of the external electrode and the wiring can be increased, whereby it is possible to provide an electronic component excellent in reliability after mounting so as to reduce the size and increase the performance of a variety of portable devices.

## Claims

1. An electronic component comprising:
a coil section including:
a coil wiring to be part of a coil; and
a via for connecting between the coil wirings;
a protecting section, which is made of a resin and covers the coil section; and
an external electrode, which is connected with the coil section and part of which is exposed from the protecting section,
wherein at least one of the external electrode and the coil section has an adhesion reinforcement structure to the protecting section.

2. The electronic component according to claim 1, further comprising:
an external electrode-via connecting section which connects the external electrode to the coil wiring,
wherein the external electrode-via connecting section has an adhesion reinforcement structure to the protecting section.

3. The electronic component according to claim 1 or 2,
wherein the coil section is a three-dimensional coil formed by electrically connecting the plurality of coil wirings formed at different layers through the plurality of vias.

4. The electronic component according to claim 1 or 2,
wherein the protecting section is a substantially rectangular solid in shape, and at least one of the external electrodes is exposed from the protecting section on not less than one surface and not more than four surfaces of the substantially rectangular solid.

5. The electronic component according to claim 1 or 2,
wherein the electronic component has a long side and a short side, and
the coil section is connected to the external electrode at the long side of the electronic component.

6. The electronic component according to claim 1 or 2,
wherein part of the external electrode and at least part of the coil section are formed on the same level.

7. The electronic component according to claim 2,
wherein the external electrode is formed of a first external electrode and a second external electrode, and
one end of the coil wiring is connected to the first external electrode through the external electrode-via connecting section, and the other end of the coil wiring is connected to the second external electrode at a long side of the electronic component.

8. The electronic component according to claim 1 or 2,
wherein the coil section has a three-dimensional structure, and
the plurality of vias are connected with the coil wirings while being alternately displaced.

9. The electronic component according to claim 1 or 2,
wherein the coil section has a three-dimensional structure,
the plurality of vias are connected with the plurality of coil wirings at positions on the substantially same perpendicular line, and
at least the adjacent vias have different diameters or shapes.

10. The electronic component according to claim 2,
wherein the coil wiring is branched into a plurality of numbers inside the protecting section, and connected to the external electrode-via connecting section through the plurality of vias at the substantially ends of the divided coil wirings.

11. The electronic component according to claim 1 or 2,
wherein at least part of the coil wiring is formed along with the external electrode on the same level as an integral object,
the coil wiring partly has a curved section, and
the curved section is curved at an angle not smaller than 30 degrees or not less than half a turn.

12. The electronic component according to claim 1,
wherein the adhesion reinforcement structure is a plurality of projections or depressions formed at the external electrode or the coil section.

13. The electronic component according to claim 1 or 2,
wherein the coil wiring is a metal mainly made of copper formed by plating, and
a resin of the protecting section is a photosensitive resin.

14. The electronic component according to claim 1 or 2,
wherein in the coil wirings, surfaces other than one surface connected with the via are formed of a plurality of metal layers.

15. The electronic component according to claim 1 or 2,
wherein a cross sectional shape of the coil wiring is a substantially rectangular.

16. The electronic component according to claim 2,
wherein the external electrode-via connecting section and part of the external electrode are formed on the same level as an integral object.

17. The electronic component according to claim 1 or 2,
wherein the coil section is formed by repeating a plurality of times a process of removing an unnecessary metal layer from a metal layer formed by covering a predetermined depression previously formed of a photosensitive resin.

18. An electronic component comprising:
a coil section including:
a coil wiring to be part of a coil; and
a via for connecting between the coil wirings;
a protecting section, which is made of a resin and covers the coil section;
an external electrode, which is connected with the coil section and part of which is exposed from the protecting section; and
an external electrode-via connecting section which connects the external electrode to the coil wiring,
wherein the external electrode or the coil section has an adhesion reinforcement structure to the protecting section.
